Europäisches Patentamt

European Patent Office

Office européen des brevets

(11) Veröffentlichungsnummer: **0 291 629**
**A2**

## (12) EUROPÄISCHE PATENTANMELDUNG

(21) Anmeldenummer: 88101350.2

(22) Anmeldetag: 30.01.88

(51) Int. Cl.⁴: **B32B 31/08** , **B32B 31/20** , **B32B 15/14**

(30) Priorität: 16.05.87 DE 3716531

(43) Veröffentlichungstag der Anmeldung:
23.11.88 Patentblatt 88/47

(84) Benannte Vertragsstaaten:
**AT CH DE GB IT LI**

(71) Anmelder: **AEG ISOLIER- UND KUNSTSTOFF GMBH**
**Otto-Hahn-Strasse 5**
**D-3500 Kassel(DE)**

(72) Erfinder: **Schäfer, Hans-Jürgen**
**Hessenring 56**
**D-3502 Vellmar(DE)**

(74) Vertreter: **Lertes, Kurt, Dr. et al**
**AEG-TELEFUNKEN AKTIENGESELLSCHAFT**
**Theodor-Stern-Kai 1**
**D-6000 Frankfurt/Main 70(DE)**

(54) **Verfahren zum kontinuierlichen Herstellen von bandförmigem Basismaterial.**

(57) Verfahren zum kontinuierlichen Herstellen von bandförmigen Basismaterial durch Verpressen einer harzgetränkten Gewebebahn (Prepreg) mit einer Kupferfolie mittels einer Doppelbandpresse unter Druck und Temperatur, wobei die Kupferfolie und das Prepreg vor bzw. bei dem Einlauf in die Doppelbandpresse vorerwärmt wird. Eine homogene Herstellung des bandförmigen Basismaterials mit über die gesamte Fläche gleichmäßigen Eigenschaften wird dadurch realisiert, daß die Vorerwärmung druckfrei auf eine Temperatur unterhalb des Schmelzpunktes des Harzes erfolgt, daß in einer ersten Preßzone (6) unter Temperaturerhöhung das Laminat unter Gelieren des Harzes gebildet wird und daß anschließend in einer zweiten Preßzone (7) bei gegenüber der ersten Preßzone erhöhter Temperatur das Laminat ausgehärtet wird, dabei werden in einer Entgasungszone (9) die flüchtigen Bestandteile abgeführt und das Laminat mit Auslauf der Doppelbandpresse in einer Konditionierzone (8) bei einer Temperatur von 150 bis 220 oC druckfrei nachbehandelt.

EP 0 291 629 A2

## Verfahren zum kontinuierlichen Herstellen von bandförmigem Basismaterial

Die Erfindung betrifft ein Verfahren zum kontinuierlichen Herstellen von bandförmigem Basismaterial (Laminat) durch Verpressen einer harzgetränkten Gewebebahn (Prepreg) mit einer Kupferfolie mittels einer Doppelbandpresse unter Druck und Temperatur, wobei die Kupferfolie und das Prepreg vor bzw. bei dem Einlauf in die Doppelbandpresse vorerwärmt wird.

Basismaterialien für kommerzielle Leiterplatten werden üblicherweise derart hergestellt, daß zunächst ein Glasgewebe mit einem System aus einem Epoxidharz und einer Härterlösung imprägniert und in einem Trockner vorpolymerisiert wird. Diese sogenannten Prepregs werden dann auf Preßformat geschnitten und mit einer Kupferfolie unter Druck und Temperatur zu einem Laminat vereinigt bzw. verarbeitet. Je nach gewünschter Dicke des Basismaterials können dabei mehrere Prepregs aufeinandergelegt werden.

Die Laminierung des Prepregs mit der Kupferfolie erfolgt in Etagenpressen oder Doppelbandpressen. Bei Verwendung der Etagenpresse wird das Prepreg mit der zugeordneten Kupferfolie zwischen zwei Edelstahlblechen angeordnet und dann zwischen zwei Heizplatten verpreßt. Es können bis zu 12 Tafeln gleichzeitig verpreßt weden. Beim Verpressen des Prepregs mit der Kupferfolie fließt aufgrund des einwirkenden Drucks und der Temperatur das vorpolymerisierte Harz in das Gewebe. Da der Druck statisch aufgebracht wird, ist auch bei niedriger Viskosität des Harzes eine gewisse Fließzeit für diesen Vorgang erforderlich. Aufgrund des Fließvorgangs verringert sich die Materialdicke des Laminats im Randbereich, was einen Druckabfall zur Folge hat, der über komprimierbare Polstermaterialien ausgeglichen werden muß. Der höhere Druck im mittleren Teil der Tafel führt zu unerwünschten Verspannungen des Glasgewebes, die wiederum bei der Weiterverarbeitung des Laminats zu einer Leiterplatte, insbesondere bei Temperatureinwirkung, unerwünschte variable Dimensionsänderungen zur Folge hat.

Eine kontinuierliche Herstellung von kupferkaschiertem Basismaterial für Leiterplatten ist mittels einer Doppelbandpresse möglich. Die Kupferfolie und das Prepreg laufen gemeinsam in die Doppelbandpresse ein und werden dort zwischen zwei Bändern zum Auslauf geführt. In der druckwirksamen Zone der Doppelbandpresse wird in bekannter Weise über eines der beiden Bänder ein Druck auf die zu verpressenden Materialien übertragen.

Das eingangs definierte Verfahren zum Herstellen von bandförmigem Basismaterial ist aus der EP-OS 01 58 027 bekannt. Insbesondere durch die Maßnahme, die imprägnierten und vorgehärteten Glasfasergewebebahnen vor dem Einlaufen in die druckwirksame Zone der Doppelbandpresse in einer Vorwärmzone vorzuwärmen, wird eine gleichmäßige Dicke und Qualität von den Randbereichen bis zu den mittleren Bereichen des Laminats erzielt.

Bei der weiter fortschreitenden Miniaturisierung der elektronischen Bauelemente wird an die Leiteplatten noch die Forderung nach einer erhöhten Packungsdichte der Bohrungen gestellt. Bei erhöhter Packungsdichte werden jedoch Dimensionsveränderungen in der Leiterplatte immer kritischer. Unerwünschte Preßspannungen lassen sich zwar durch Tempern des Basismaterials reduzieren, was jedoch nicht den technischen Anforderungen genügt. Da die Dimensionsveränderungen in der Regel vom Randbereich bis zur Mitte des Laminats verlaufen, werden letztlich Leiterplatten mit unterschiedlichen Eigenschaften erhalten.

Der Erfindung liegt die Aufgabe zugrunde, das eingangs definierte Verfahren derart weiterzubilden, daß die Herstellung eines bandförmigen, homogenen Basismaterials mit über die gesamte Fläche gleichmäßigen Eigenschaften ermöglicht.

Diese Aufgabe wird gemäß der Erfindung dadurch gelöst, daß die Vorerwärmung druckfrei auf eine Temperatur unterhalb des Schmelzpunktes des Harzes erfolgt, daß vor dem Verpressen in einer Entgasungszone die flüchtigen Bestandteile des Prepregs abgeführt werden, daß in einer ersten Preßzone unter Temperaturerhöhung das Laminat unter Gelieren des harzes gebildet wird und daß anschließend in einer zweiten Preßzone bei gegenüber der ersten Preßzone erhöhter Temperatur das Laminat ausgehärtet wird.

Um die Dimensionsstabilität des Basismaterials zu gewährleisten, ist es zunächst erforderlich, die Vorspannung des Prepregs so gering wie möglich zu halten. Dazu wird zumindest in der ersten Preßzone bei Drücken von 10 bis 20 bar bei einer niedrigen Schmelzviskosität des Harzes gearbeitet. Bisher wurde das Laminat in der Presse gekühlt, wodurch noch verbleibende Spannungen eingefroren wurden. Es wurde nun überraschenderweise gefunden, daß ein praktisch spannungsfreies Laminat dann erhalten wird, wenn der Doppelbandpresse am Auslauf eine Konditionierzone nachgeschaltet ist, in welcher das Laminat druckfrei auf eine vorbestimmte Temperatur abkühlt, um anschließend hinter der Konditionierzone mittels forcierter Luftkühlung auf Raumtemperatur gebracht zu werden.

Weiterbildungen der Erfindung sind den Unteransprüchen zu entnehmen.

Das Wesen der Erfindung soll anhand der Zeichnungen näher erläutert werden. Es zeigen:

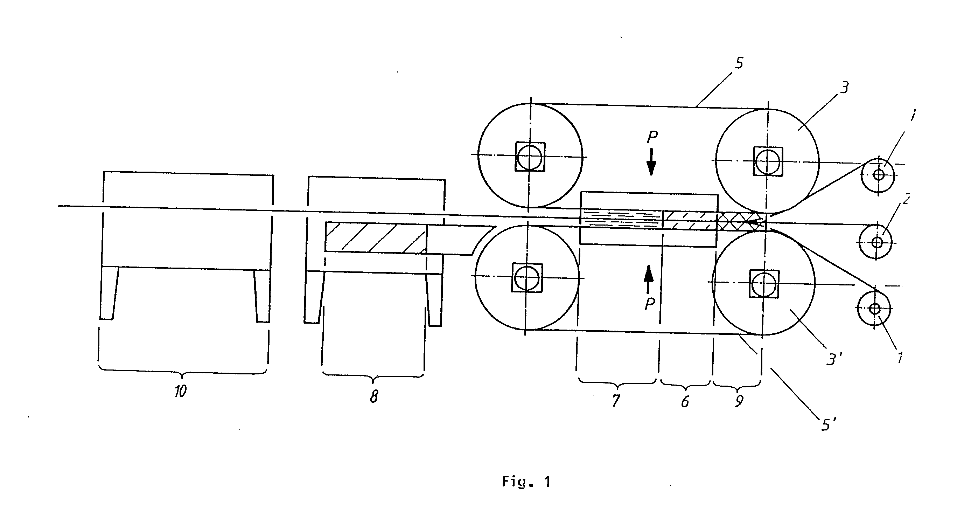

Fig. 1 eine zur Durchführung des Verfahrens gemäß der Erfindung modifizierte Doppelbandpresse und

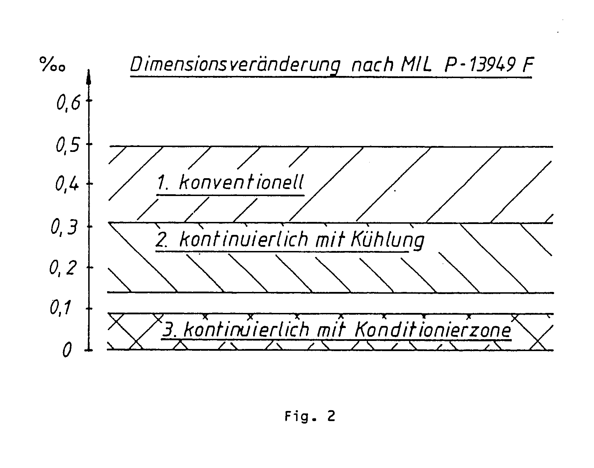

Fig. 2 die Bereiche der Dimensionsveränderungen einer Leiterplatte in Abhängigkeit von der Art der Kühlung des Laminats.

Die Kupferfolie 1 und das Prepreg 2 laufen zwischen den beiden Walzen 3, 3′ in die Doppelbandpresse 4 ein. Die Kupferfolie und das Prepreg bzw. das Laminat durchlaufen die Doppelbandpresse zwischen den beiden umlaufenden Bändern 5 und 5′. Der Abstand zwischen den beiden Walzen 3 und 3′ ist so groß zu wählen, daß die Kupferfolie und das Prepreg druckfrei einlaufen und in der dem Einlauf nachgeschalteten Entgasungszone 9 nicht aufeinander aufliegen, so daß die flüchtigen Bestandteile des Prepregs am Rand der einlaufenden Bahnen abgesaugt werden können. Die Walzen 3 und 3′ werden auf einer Temperatur von 80 bis 100 °C gehalten. Eine dementsprechende Erwärmung des Prepregs reicht zur Entgasung desselben aus. Um eine weitere Aufheizung des Prepregs in der Entgasungszone zu vermeiden, muß dafür Sorge getragen werden, daß die Prepregs nicht mit den Bändern 5 und 5′ bzw. den Kupferfolien in Berührung stehen. Die Kupferfolie und das Prepreg werden somit bei vorgegebener konstanter Temperatur druckfrei durch die Entgasungszone 9 geführt.

Der eigentliche Arbeitsbereich der Doppelbandpresse besteht aus den beiden Preßzonen 6 und 7. In der ersten Preßzone 6 wird die Temperatur auf maximal 170 °C erhöht, wobei unter Druck das Laminat unter Gelieren des Harzes gebildet wird. Anschließend wird in der zweiten Preßzone 7 bei einer Temperatur von 200 bis 240 °C das Laminat ausgehärtet. Die Verweilzeit in den beiden Zonen sollte 60 sec nicht überschreiten.

Der Doppelbandpresse ist eine Könditionierzone 8 nachgeschaltet, in der das Laminat auf eine Temperatur von ca. 150 °C in 30 bis 60 sec abgekühlt wird. Dazu wird gegebenenfalls die Abluft in der Konditionierzone entsprechend eingestellt. Die Transportfläche der Konditionierzone ist mit einem hitzebeständigen Vlies ausgelegt. Hinter der Konditionierzone durchläuft das Laminat schließlich einen Luftkühler, wo es auf Raumtemperatur abgekühlt und dann abgelenkt wird.

Eine wesentliche Verbesserung des Basismaterials bezüglich der Heißdampffestigkeit und Erweichungstemperatur wird dadurch erzielt, daß die flüchtigen Bestandteile des Prepregs in einer Entgasungszone abgeführt werden. Eine Gegenüberstellung der Werte ist der nachfolgenden Tabelle zu entnehmen.

| | **Basismaterial** | |
|---|---|---|
| | mit Entgasungszone | ohne Entgasungszone |
| Heißdampffestigkeit nach IEC-249 | $> 2$ h | $\gtrsim 1$ h |
| Erweichungstemperatur Tg nach DCS | $> 135\ ^{\circ}C$ | $\leq 130\ ^{\circ}C$ |

**Ansprüche**

1. Verfahren zum kontinuierlichen Herstellen von bandförmigem Basismaterial durch Verpressen einer harzgetränkten Gewebebahn (Prepreg) mit einer Kupferfolie mittels einer Doppelbandpresse unter Druck und Temperatur, wobei die Kupferfolie und das Prepreg vor bzw. bei dem Einlauf in die Doppelbandpresse vorerwärmt wird, **dadurch gekennzeichnet,** daß die Vorerwärmung druckfrei auf eine Temperatur unterhalb des Schmelzpunktes des Harzes erfolgt, daß in einer ersten Preßzone (6) unter Temperaturerhöhung das Laminat unter Gelieren des Harzes gebildet wird und daß anschließend in einer zweiten Preßzone (7) bei gegenüber der ersten Preßzone erhöhter Temperatur das Laminat ausgehärtet wird.

2. Verfahren nach Anspruch 1,
**dadurch gekennzeichnet,**
daß vor dem Verpressen in einer Entgasungszone (9) die flüchtigen t werden.

3. Verfahren nach Anspruch 1 oder 2,
**dadurch gekennzeichnet,**
daß das Laminat in einer an den Auslauf der Doppelbandpresse anschließenoei. einer Temperatur von 150 bis 220 °C druckfrei nachbehandelt wird.

4. Verfahren nach Anspruch 3,
**dadurch gekennzeichnet,**
daß das Laminat nach Verlassen der Konditionierzone (8) auf Raumtemperatur abgekühlt wird.

5. Verfahren nach Anspruch 4,
**dadurch gekennzeichnet**
, daß die Abkühlung durch forcierte Luftkühlung erfolgt.

6. Verfahren nach einem der Ansprüche 1 bis 5,
**dadurch gekennzeichnet,**
daß in den beiden Preßzonen (6, 7) bei einem Druck von 10 bis 25 bar verpreßt wird.

7. Verfahren nach einem der Ansprüche 1 bis 6,
**dadurch gekennzeichnet,**
daß die Temperatur in der ersten Preßzone (6) 100 bis 150 °C beträgt.

8. Verfahren nach einem der Ansprüche 1 bis 7,
**dadurch gekennzeichnet,**
daß die Temperatur in der zweiten Preßzone (7) 180 bis 240 °C beträgt.

9. Doppelbandpresse zur Durchführung des Verfahrens nach einem der Ansprüche 1 bis 8,
**dadurch gekennzeichnet,**
daß eine erste und zweite Preßzone (6, 7) vorgesehen sind, deren Temperatur unabhängig voneinander einstell- und regelbar ist.

10. Doppelbandpresse nach Anspruch 9,
**dadurch gekennzeichnet,**
daß den beiden Preßzonen (6, 7) eine Entgasungszone (9) vorgeschaltet ist, derart, daß die in dem Prepreg freigesetzten flüchtigen Bestandteile am Rand der beiden Bänder der Doppelbandpresse abgesaugt werden.

11. Doppelbandpresse nach Anspruch 9 oder 10,
**dadurch gekennzeichnet,**
daß der Abstand der einlaufseitigen Walzen größer (3, 3') als 10 mm ist.

12. Doppelbandpresse nach einem der Ansprüche 9 bis 11,
**dadurch gekennzeichnet,**
daß die erste Preßzone (6) 1 bis 2 m lang ist.

13. Doppelbandpresse nach einem der Ansprüche 9 bis 12,
**dadurch gekennzeichnet,**
daß die zweite Preßzone (7) 4 bis 6 m lang ist.

14. Doppelbandpresse nach einem der Ansprüche 9 bis 13,
**dadurch gekennzeichnet,**
daß dem Auslauf der Doppelbandpresse eine druckfreie Konditionierzone (8) nachgeschaltet ist.

15. Doppelbandpresse nach Anspruch 14,
**dadurch gekennzeichnet,**
daß die Konditionierzone (8) 1 bis 3 m lang ist.

16. Doppelbandpresse nach Anspruch 14 oder 15,
**dadurch gekennzeichnet,**
daß die Konditionierzone (8) mit einem hitzebeständigen Vlies ausgelegt ist.

Fig. 1

0 291 629

Fig. 2